# EUROPEAN PATENT SPECIFICATION

(11) **EP 4 170 367 B1**
(45) Date of publication and mention of the grant of the patent: **11.06.2025**
(21) Application number: 21856159.5
(22) Date of filing: 09.08.2021
(51) Int. Cl.: G01R 31/367, G01R 31/36, G01R 31/382, G01R 31/396, H01M 10/48

(54) **BATTERY CAPACITY ESTIMATION APPARATUS AND METHOD**
VORRICHTUNG UND VERFAHREN ZUR SCHÄTZUNG DER BATTERIEKAPAZITÄT
DISPOSITIF ET PROCÉDÉ D'ESTIMATION DE CAPACITÉ DE BATTERIE

(30) Priority: 13.08.2020 KR 20200101866
(43) Date of publication of application: 26.04.2023
(73) Proprietor: LG Energy Solution, Ltd., Seoul 07335 (KR)
(72) Inventor: LIM, Bo Mi, Daejeon 34122 (KR)
(74) Representative: Plasseraud IP
(86) International application number: PCT/KR2021/010477
(87) International publication number: WO 2022/035153

(56) References cited:
- JP-A- 2017 062 149
- JP-A- 2019 113 524
- JP-A- H1 010 213
- KR-A- 20160 101 506
- KR-A- 20160 107 095
- US-A1- 2016 195 587
- US-A1- 2017 003 352
- US-A1- 2019 025 381
- US-A1- 2020 081 070

## Description

### [TECHNICAL FIELD]

### CROSS-REFERENCE TO RELATED APPLICATION

This application claims priority to and the benefit of Korean Patent Application No. 10-2020-0101866 filed in the Korean Intellectual Property Office on August 13, 2020.

### TECHNICAL FIELD

The present invention relates to an apparatus and method for estimating a capacity of a battery by configuring a model separately for data that is easy to analyze and data that is not easy to analyze.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium ion batteries. Among the secondary batteries, a lithium ion battery has a much higher energy density than those of the conventional Ni/Cd batteries, Ni/MH batteries, etc. Moreover, the lithium ion battery may be manufactured to be small and lightweight, such that the lithium ion battery has been used as a power source of mobile devices. In addition, the lithium ion battery is attracting attention as a next-generation energy storage medium as a usage range thereof is expanded to a power source of electric vehicles.

Furthermore, the secondary battery is generally used as a battery pack including a battery module where a plurality of battery cells are connected to one another in series and/or in parallel. The battery pack may be managed and controlled by a battery management system in terms of a state and an operation.

Such a secondary battery is subject to a lot assembly test (LAT) in a production process to determine a quality of each cell in production. Generally, one sample may be selected for each lot, which is a unit of a plurality of cells, to perform the LAT. The LAT is intended to check if a capacity of the secondary battery is greater than or equal to a specific level even after 300 cycles through accelerated degradation of the secondary battery.

Through the LAT, full charging and discharging may be performed under the same experiment condition for one through 300 cycles, and it is determined whether the cell has passed the test based on a state of health (SOH) life in the 300 cycles. However, data logged in the LAT may include data that is easy to analyze and data that is not easy to analyze, together, such that there may be a difficulty in analysis of a data value and accuracy may be degraded.

Prior art document US2016/0195587 discloses an arrangement for estimating battery capacity based on voltage/current measurements, involving dividing up measured data into time segments and applying a model thereto.

### [DISCLOSURE]

### [TECHNICAL PROBLEM]

The present invention has been made to solve the foregoing problems, and aims to provide a battery capacity estimation apparatus and method in which data that is easy to analyze and data that is not easy to analyze are distinguished from among logging data of a battery cell and a capacity estimation model is applied to each data, thereby accurately and efficiently estimating a capacity of the battery cell.

### [TECHNICAL SOLUTION]

A battery capacity estimation apparatus according to an embodiment of the present invention includes a voltage measuring unit configured to measure a voltage of a battery cell, a filtering unit configured to determine voltage data as first data when a logging pattern of the voltage data of the battery cell deviates from a preset reference range, a statistical analyzing unit configured to determine second data through statistical analysis on the voltage data of the battery cell, and a capacity estimating unit configured to estimate a capacity by applying data, classified by the filtering unit or the statistical analyzing unit for a battery cell that is a measurement target, to capacity estimation models generated separately for the first data and the second data.

A battery capacity estimation method according to an embodiment of the present invention includes measuring a voltage of a battery cell, determining voltage data as first data when a logging pattern of the voltage data of the battery cell deviates from a preset reference range, determining second data through statistical analysis on the voltage data of the battery cell, and estimating a capacity of the battery cell by applying the first data and the second data to capacity estimation models, respectively.

### [ADVANTAGEOUS EFFECTS]

With a battery capacity estimation apparatus and method according to the present invention, data that is easy to analyze and data that is not easy to analyze may be distinguished from among logging data of a battery cell and a capacity estimation model may be applied to each data, thereby accurately and efficiently estimating a capacity of the battery cell.

### [DESCRIPTION OF DRAWINGS]

FIG. 1 is a block diagram of a general battery rack.
FIG. 2 is a block diagram showing a structure of a battery capacity estimation apparatus according to an embodiment of the present invention.
FIG. 3 is a flowchart showing an operation, performed by a battery capacity estimation apparatus, of classifying data according to an embodiment of the present invention.
FIG. 4 is a diagram showing a correlation between logging data and a capacity of a battery cell.
FIG. 5 is a diagram showing that logging data of a battery cell is classified into a plurality of clusters by a battery capacity estimation apparatus according to an embodiment of the present invention.
FIG. 6 is a diagram showing that logging data of all battery cells are classified into a plurality of clusters by a battery capacity estimation apparatus according to an embodiment of the present invention.
FIG. 7 shows an example of a capacity estimation model (long short-term memory networks (LSTM)) of a battery capacity estimation apparatus according to an embodiment of the present invention.
FIG. 8 is a flowchart showing a battery capacity estimation method according to an embodiment of the present invention.
FIG. 9 is a block diagram showing a hardware structure of a battery capacity estimation apparatus according to an embodiment of the present invention.

### [MODE FOR INVENTION]

Hereinafter, various embodiments of the present invention will be described in detail with reference to the accompanying drawings. In this document, identical reference numerals will be used for identical components in the drawings, and the identical components will not be redundantly described.

For various embodiments of the present invention disclosed in this document, specific structural or functional descriptions are only exemplified for the purpose of describing the embodiments of the present invention, and various embodiments of the present invention may be implemented in various forms, and should not be construed as being limited to the embodiments described in this document.

As used in various embodiments, the terms "1st, "2nd", "first", "second", or the like may modify various components regardless of order and/or importance, and do not limit the components. For example, a first component may be named as a second component without departing from the right scope of the present disclosure, and similarly, the second component may be named as the first component.

Terms used in the present document are used for only describing a specific exemplary embodiment of the disclosure and may not have an intention to limit the scope of other exemplary embodiments of the disclosure. It is to be understood that the singular expressions include plural expressions unless the context clearly dictates otherwise.

All of the terms used herein including technical or scientific terms have the same meanings as those generally understood by an ordinary skilled person in the related art. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some cases, the terms defined herein may be interpreted to exclude embodiments of the present disclosure.

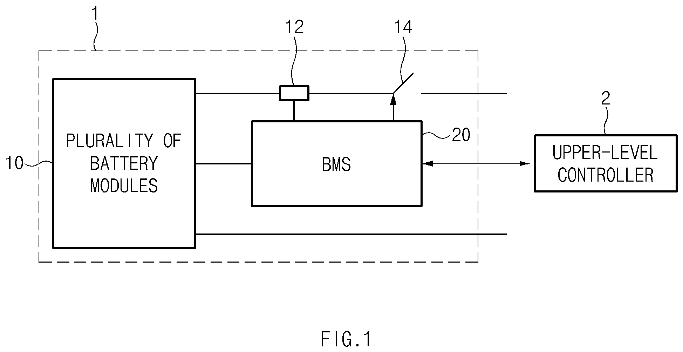

FIG. 1 is a block diagram of a general battery rack.

Referring to FIG. 1, a battery control system including a battery rack 1 and a upper-level controller 2 included in a upper-level system according to an embodiment of the present invention is schematically shown.

As shown in FIG. 1, the battery rack 1 may include a battery module 10 that includes one or more battery cells and is chargeable/dischargeable, a switching unit 14 serially connected to a positive (+) terminal side or a negative (-) terminal side of the battery module 10 to control a charging/discharging current flow of the battery module 10, and a battery management system (e.g., RBMS) 20 for control and management to prevent over-charging and over-discharging by monitoring a voltage, a current, a temperature, etc., of the battery rack 1. The battery rack 1 may include a plurality of battery modules 10, sensors 12, switching units 14, and battery management systems 20.

Herein, as the switching unit 14 which is an element for controlling a current flow for charging or discharging of the plurality of battery modules 10, for example, at least one relay, magnetic contactor, etc., may be used according to specifications of the battery rack 1.

The battery management system 20, which is an interface for receiving measurement values of the above-described various parameters, may include a plurality of terminals and a circuit, etc., connected thereto to process input values. The battery management system 20 may control on/off of the switching unit 14, e.g., a relay, a contactor, etc., and may be connected to the battery module 10 to monitor the state of each battery module 10.

Meanwhile, the battery management system 20 according to the present invention may perform regression analysis on a voltage of a battery cell through a separate program, as will be described below. An abnormal type of the battery cell may be classified using a calculated regression equation.

The upper-level controller 2 may transmit a control signal for the battery module 10 to the battery management system 20. Thus, the battery management system 20 may also be controlled in terms of an operation thereof based on a signal applied from the upper-level controller 2. Meanwhile, the battery cell according to the present invention may be included in the battery module 10 used for an energy storage system (ESS). In this case, the upper-level controller 2 may be a controller (BBMS) of a battery bank including a plurality of racks or an ESS controller for controlling the entire ESS including a plurality of banks. However, the battery rack 1 is not limited to such a purpose.

Such configurations of the battery rack 1 and the battery management system 20 are well-known configurations, and thus will not be described in detail.

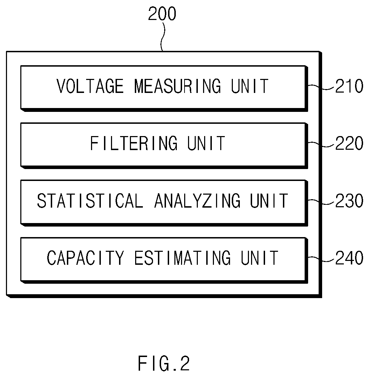

FIG. 2 is a block diagram showing a structure of a battery capacity estimation apparatus according to an embodiment of the present invention.

Referring to FIG. 2, a battery capacity estimation apparatus 200 according to an embodiment of the present invention may include a voltage measuring unit 210, a filtering unit 220, a static analyzing unit 230, and a capacity estimating unit 240. For example, the battery capacity estimation apparatus 200 according to an embodiment of the present invention may estimate a capacity of the battery cell by analyzing charging and discharging data of the battery in real time, or may perform a test by sampling a failure before mounting in a module in manufacturing of the battery cell.

The voltage measuring unit 210 may measure a voltage of the battery cell. In this case, the voltage measuring unit 210 may measure the voltage of the battery cell at specific time intervals. For example, the voltage measuring unit 210 may measure a voltage for a rest period after charging or discharging of the battery cell. In addition, the voltage measuring unit 210 may measure current flowing in the battery cell.

When a logging pattern of voltage data of the battery cell deviates from a preset reference range, the filtering unit 220 may determine the voltage data as first data. More specifically, when at least one of a logging time and the number of voltage data of the battery cell deviates from a reference range, the filtering unit 220 may determine the voltage data as the first data.

For example, the logging pattern of the voltage data of the battery cell may be intended to extract four voltage data in the unit of 5 minutes. In this case, there may be an error in a logging time like when a logging time of the voltage data of the battery cell is (59, 10, 20, 5 minutes) or specific logging data may be omitted like when a logging time is (5, 10, 20 minutes) or (10, 15, 20 minutes), etc. In this case, the filtering unit 220 may classify corresponding data as the first data.

The statistical analyzing unit 230 may determine second data through statistical analysis on the voltage data of the battery cell. In this case, the statistical analyzing unit 230 may perform statistical analysis on data other than data determined as the first data by the filtering unit 220. The statistical analyzing unit 230 may calculate differential data dV/dt, for the battery cell, of a voltage with respect to a time. As will be described below, the differential data of the voltage with respect to the time shows more prominent tendency than logged voltage data, such that the statistical analyzing unit 230 may use the differential data of the voltage with respect to the time.

More specifically, the statistical analyzing unit 230 may extract principal component data for voltage data by performing principal component analysis (PCA) on the differential data.

The statistical analyzing unit 230 may calculate a plurality of clusters through k-means clustering on the principal component data, and determine differential data included in a particular cluster as second data and differential data not included in the cluster as the first data.

For example, the first data may be data in which the voltage data of the battery cell is in a discontinuous form, and the second data may be data in which the voltage data of the battery cell is in a continuous form. That is, the first data may be data that is not be easy to analyze and the second data may be data that is easy to analyze.

As such, the battery capacity estimation apparatus 200 according to an embodiment of the present invention may apply a capacity estimation model separately for the first data and the second data which have different general shapes, thereby improving accuracy in comparison to when data where the first data and the second data are combined is used conventionally. For example, with the battery capacity estimation apparatus 200 according to an embodiment of the present invention, in charging and discharging of the battery, when a capacity of 300 cycles is predicted using data regarding initial 100 cycles, accuracy may be improved by separately applying data to the capacity estimation model.

The capacity estimation unit 240 may estimate a capacity by applying data, classified by the filtering unit 220 or the statistical analyzing unit 230 for the battery cell that is a measurement target, to the capacity estimation model generated separately for the first data and the second data. For example, the capacity estimation model may be a long short-term memory networks (LSTM) model. In this case, the capacity estimation model generated for each of the first data and the second data may include a different parameter value.

Meanwhile, although not shown in FIG. 2, the battery capacity estimation apparatus 200 according to an embodiment of the present invention may include a storing unit. In this case, the storing unit may store various data such as voltage data measured by the voltage measuring unit 210, voltage data classified by the filtering unit 220 and the statistical analyzing unit 230, a capacity estimation program, etc. The battery capacity estimation apparatus 200 according to an embodiment of the present invention may operate by transmitting and receiving the above-described data in communication with an external server through a communicating unit (not shown), instead of including the storing unit.

As such, with the battery capacity estimation apparatus 200 according to the present invention, data that is easy to analyze and data that is not easy to analyze may be distinguished from among logging data of a battery cell and a capacity estimation model may be applied to each data, thereby accurately and efficiently estimating a capacity of the battery cell.

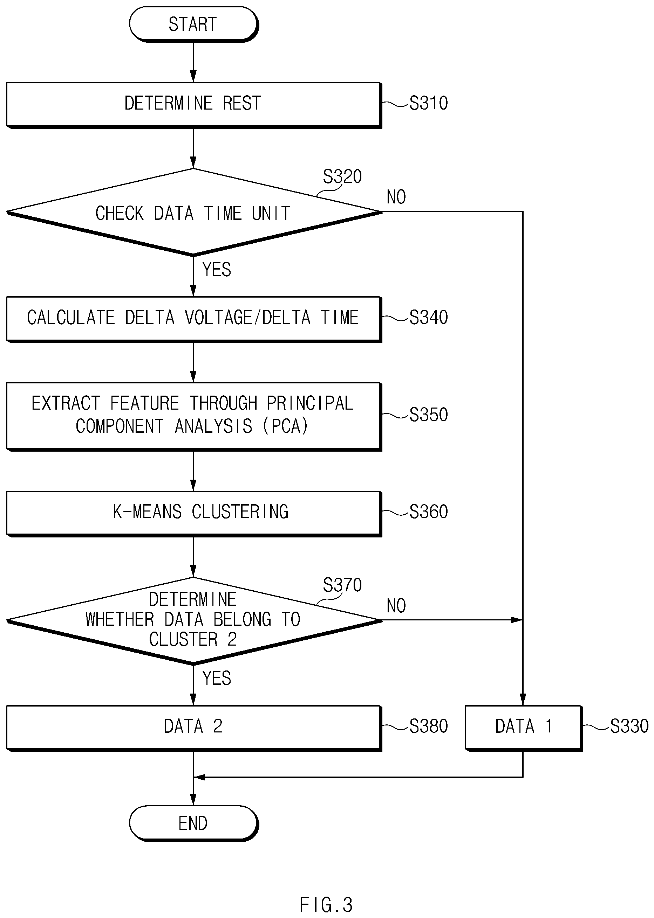

FIG. 3 is a flowchart showing an operation, performed by a battery capacity estimation apparatus, of classifying data according to an embodiment of the present invention.

Referring to FIG. 3, the battery capacity estimation apparatus according to an embodiment of the present invention may determine whether a battery cell is currently in a rest state (that is, current = 0) in operation S310. When the battery cell is in the rest state, it may be determined whether voltage data is logged according to a preset scheme, in operation S320. For example, the logging scheme may be logging four voltage data at an interval of 5 minutes.

When the voltage data is out of the preset logging scheme (NO), the voltage data may be classified as the first data in operation S330. On the other hand, when the voltage data is logged normally according to the preset scheme (YES), differential data dV/dt of the voltage data with respect to a time may be calculated in operation S340.

Then, feature (principal component) data may be extracted through PCA with respect to the differential data of the voltage. In this case, by performing PCA on the differential data, a dimension of data may be reduced. By applying k-mean clustering to the principal component data, the data may be classified into a plurality of clusters in operation S360.

When the classified data is not included in a particular cluster (e.g., Cluster 2) (NO), the data may be classified as the first data in operation S370. On the other hand, when the data is included in the particular cluster (YES), the data may be classified as second data in operation S380.

As such, with the battery capacity estimation apparatus according to an embodiment of the present invention, voltage data may be identified by checking a time unit of logging data and using PCA and a k-mean clustering algorithm. Thus, data having similar features may be classified, thereby efficiently and accurately performing battery capacity estimation.

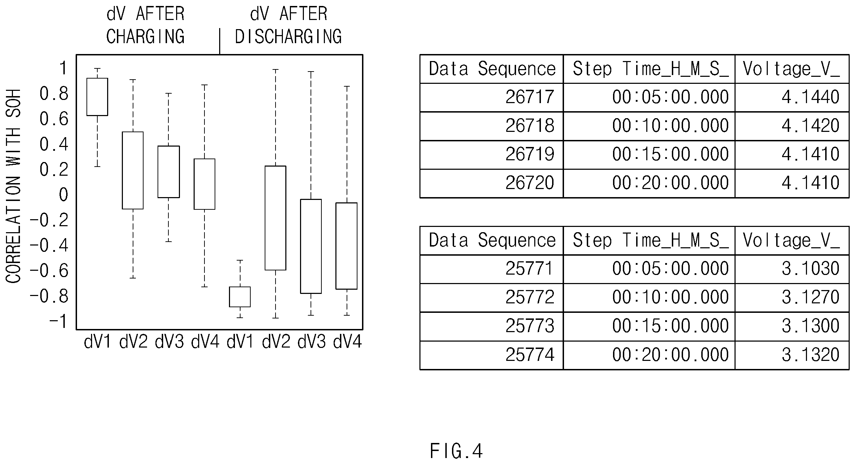

FIG. 4 is a diagram showing a correlation between logging data and a capacity of a battery cell.

In FIG. 4, a left graph may indicate a correlation with a battery capacity (e.g., a SOH) (a y axis) with respect to each of differential data (dV1, dV2, dV3, and dV4) (an x axis) of a voltage with respect to a time after charging and discharging, and a right table may indicate logging data of a voltage after charging and discharging of the battery.

Referring to FIG. 4, the x axis may indicate voltage differential data dV1, dV2, dV3, and dV4 after charging and voltage differential data dV1, dV2, dV3, and dV4 after discharging. In this case, in the graph of FIG. 4, a correlation with a battery capacity may be high as a y-axis value is close to 1 or -1 and a length of a vertical bar is short. That is, it may be seen that data (25 and 29) immediately after charging and discharging has a higher correlation with a battery capacity value than other data. This is because a voltage change immediately after charging and discharging is more distinct than a voltage change thereafter.

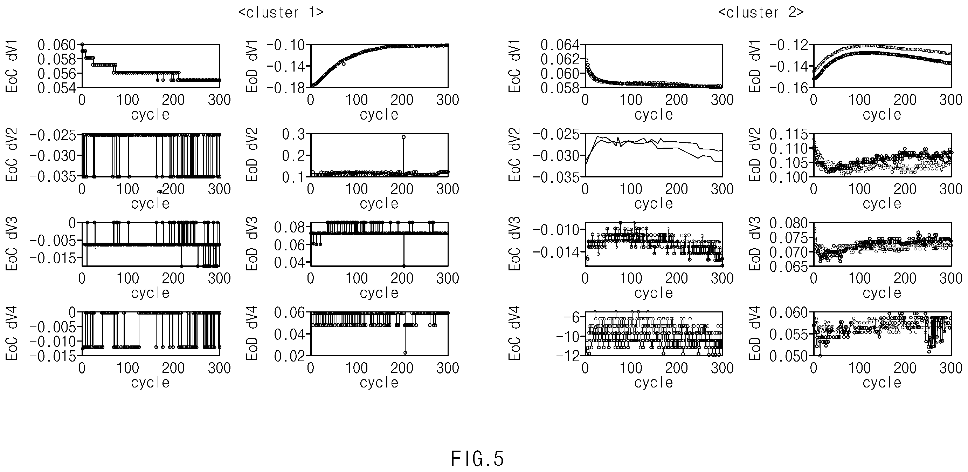

FIG. 5 is a diagram showing that logging data of a battery cell is classified into a plurality of clusters by a battery capacity estimation apparatus according to an embodiment of the present invention.

Referring to FIG. 5, an x axis may indicate the number of charging and discharging cycles of a battery cell and a y axis may indicate differential data dV1 through dV4 of a voltage with respect to a time in a rest period after charging and discharging of the battery cell. Cluster 1 may indicate the above-described first data and Cluster 2 may indicate the above-described second data.

As shown in FIG. 5, the first data belonging to Cluster 1 may indicate that data is relatively discontinuous. That is, the first data may be irregular by nature, and thus may not be easy to perform battery capacity analysis thereon.

Meanwhile, the second data belonging to Cluster 2 may be continuous and have a gentle curve when compared to the first data. That is, the second data may have more constant tendency than the first data and may be easy to analyze.

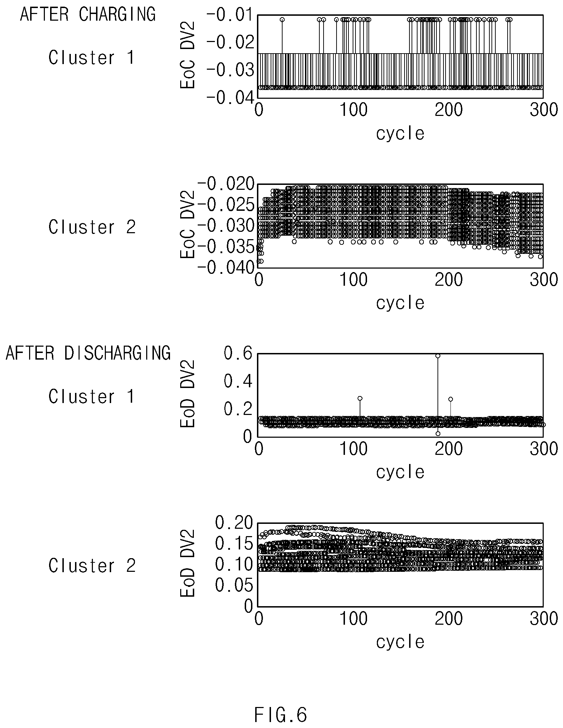

FIG. 6 is a diagram showing that logging data of all battery cells are classified into a plurality of clusters by a battery capacity estimation apparatus according to an embodiment of the present invention.

Referring to FIG. 6, an x axis may indicate the number of charging and discharging cycles of a battery cell, and a y axis may indicate differential data dV2 of a voltage with respect to a time in a rest period after charging and discharging of the entire battery cell.

Like in FIG. 5, even when data of the entire battery cells are summed, data belonging to Cluster 1 may often protrude irregularly from an upper end or a lower end. On the other hand, data belonging to Cluster 2 may have a gentle form when compared to Cluster 1. Thus, a result may be more accurately calculated in capacity estimation of the battery.

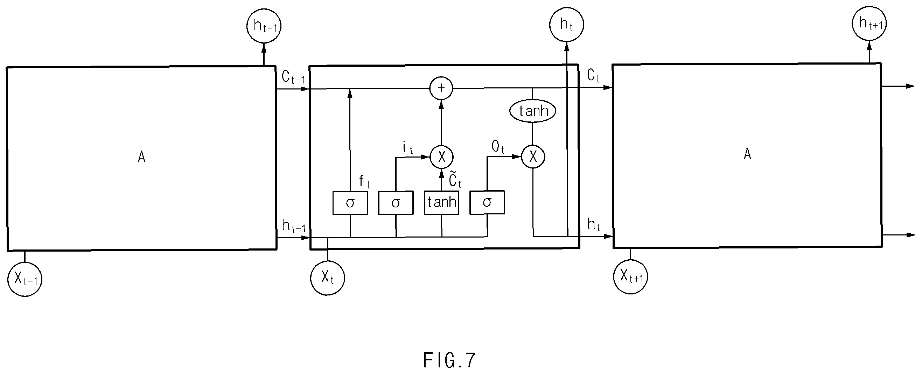

FIG. 7 shows an example of an LSTM of a battery capacity estimation apparatus according to an embodiment of the present invention.

The capacity estimation model shown in FIG. 7 may indicate an LSTM. In FIG. 7, C may indicate long-term information, h may indicate information in a previous step, σ and tanh may indicate activation functions, W may indicate a weight value, and b may indicate noise. The LSTM of FIG. 7 may include a forget gate layer, a decision layer, a new state value updating operation, and an output value deciding operation.

More specifically, the forget gate layer may determine whether to retain (1) or discard (0) certain information with an input of ht-1 and Xt having an output value between 0 and 1. In addition, in the decision layer, a value to be updated for storing a new state may be determined. In this case, a value to be updated may be determined in the input gate layer, and a vector C of new candidate values to be newly added to a cell state may be generated in the tanh layer.

Moreover, in the new cell state updating operation, an old cell state Ct-1 may be updated into a new cell state Ct. In the output value determining operation, a value to be output may be determined and a value between -1 and 1 for a cell state may be extracted through a tanh function, after which an output value may be multiplied by the output value of the forget gate layer.

As such, when the foregoing time-series voltage data is input to the capacity estimation model shown in FIG. 7, a capacity value (e.g., a capacity %) of the battery cell may be output through the foregoing processes. Meanwhile, the LSTM model of FIG. 7 has a known configuration and thus will not be described in detail.

However, the LSTM of FIG. 7 is merely an example, such that the capacity estimation model according to the present invention is not limited thereto and various estimation models may be used.

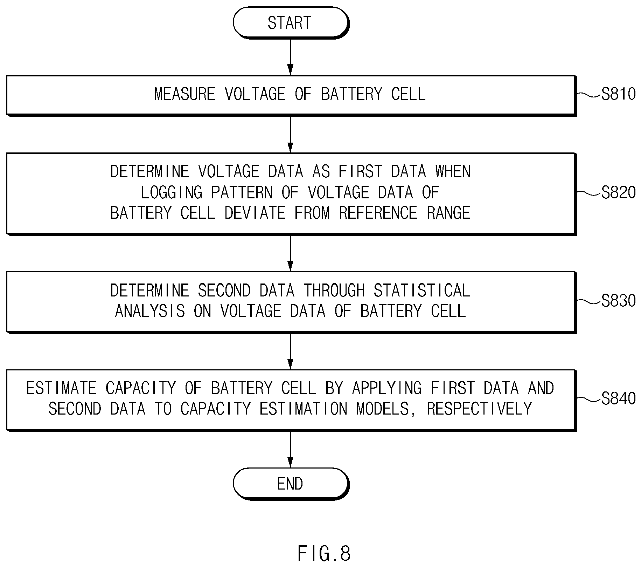

FIG. 8 is a flowchart showing a battery capacity estimation method according to an embodiment of the present invention.

Referring to FIG. 8, a battery capacity estimation method according to an embodiment of the present invention measures a voltage of a battery cell in operation S810. In this case, in operation S810, the voltage of the battery cell may be measured at specific time intervals. For example, a voltage may be measured for a rest period after charging or discharging of the battery cell.

When a logging pattern of voltage data of the battery cell deviates from a preset reference range, the voltage data may be determined as the first data, in operation S820. More specifically, when at least one of a logging time and the number of voltage data of the battery cell deviates from the reference range, the voltage data may be determined as the first data. For example, the logging pattern of the voltage data of the battery cell may be intended to extract four voltage data in the unit of 5 minutes.

Next, second data may be determined through statistical analysis on the voltage data of the battery cell, in operation S830. Differential data dV/dt, for the battery cell, of a voltage with respect to a time may be calculated in operation S830. More specifically, principal component data for voltage data may be extracted by performing PCA on the differential data, in operation S830. A plurality of clusters may be calculated through k-means clustering on the principal component data, and differential data included in a particular cluster may be determined as the second data and differential data not included in the cluster as the first data.

Last, the first data and the second data extracted in operations S820 and S830 may be applied to the capacity estimation model, respectively, thereby estimating the capacity of the battery cell in operation S840. For example, the capacity estimation model may be an LSTM model. In this case, the capacity estimation models of the first data and the second data may be identical, but parameter values input to the capacity estimation models may be different.

As such, with the battery capacity estimation method according to the present invention, data that is easy to analyze and data that is not easy to analyze may be distinguished from among logging data of a battery cell and a capacity estimation model may be applied to each data, thereby accurately and efficiently estimating a capacity of the battery cell.

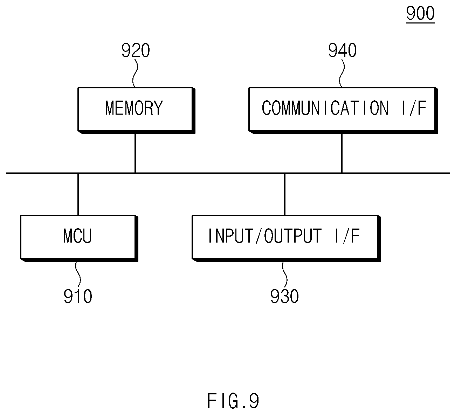

FIG. 9 is a block diagram showing a hardware structure of a battery abnormality diagnosis apparatus according to an embodiment of the present invention.

Referring to FIG. 9, a battery capacity estimation apparatus 900 according to an embodiment of the present invention may include a microcontroller unit (MCU) 910, a memory 920, an input/output interface (I/F) 930, and a communication I/F 940.

The MCU 910 may be a processor that executes various programs (e.g., a battery capacity estimation program, a principal component analysis program, a k-means clustering program, etc.) stored in the memory 920, processes various data for data classification, capacity estimation, etc., of the battery cell through these programs, and executes the above-described functions of FIG. 2.

The memory 920 may store various programs regarding statistical analysis, capacity estimation, etc., of the battery cell. Moreover, the memory 920 may store various data such as voltage data of the battery cell, differential data of a voltage of the battery cell, etc.

The memory 920 may be provided in plural, depending on a need. The memory 920 may be a volatile or nonvolatile memory. For the memory 920 as the volatile memory, random access memory (RAM), dynamic RAM (DRAM), static RAM (SRAM), etc., may be used. For the memory 920 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 720 are merely examples and are not limited thereto.

The input/output I/F 930 may provide an interface for transmitting and receiving data by connecting an input device (not shown) such as a keyboard, a mouse, a touch panel, etc., and an output device such as a display (not shown), etc., with the MCU 710.

The communication I/F 940, which is a component capable of transmitting and receiving various data to and from a server, may be various types of devices capable of supporting wired or wireless communication. For example, a program for statistical analysis and capacity estimation or various data may be transmitted and received to and from a separately provided external server through the communication I/F 940.

As such, a computer program according to an embodiment of the present invention may be recorded in the memory 920 and processed by the MCU 910, thus being implemented as a module that performs function blocks shown in FIG. 2.

Even though all components constituting an embodiment of the present invention have been described above as being combined into one or operating in combination, the present invention is not necessarily limited to the embodiment. That is, within the object scope of the present invention, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present invention.

The above description is merely illustrative of the technical idea of the present invention, and various modifications and variations will be possible without departing from the essential characteristics of the present invention by those of ordinary skill in the art to which the present invention pertains. Therefore, the embodiments disclosed in the present invention are intended for description rather than limitation, and the scope of the present invention is not limited by these embodiments. The protection scope of the present invention is defined by the following claims.

## Claims

1. A battery capacity estimation apparatus comprising:
a voltage measuring unit (210) configured to measure a voltage of a battery cell;
a filtering unit (220) configured to determine voltage data as first data when a logging pattern of the voltage data of the battery cell deviates from a preset reference range;
a statistical analyzing unit (230) configured to determine second data through statistical analysis on the voltage data of the battery cell; and
a capacity estimating unit (240) configured to estimate a capacity by applying data, classified by the filtering unit or the statistical analyzing unit for a battery cell that is a measurement target, to capacity estimation models generated separately for the first data and the second data.

2. The battery capacity estimation apparatus of claim 1, wherein the statistical analyzing unit is configured to perform statistical analysis on data other than data determined as the first data by the filtering unit.

3. The battery capacity estimation apparatus of claim 1, wherein the statistical analyzing unit is configured to calculate differential data of a voltage of the battery cell with respect to a time.

4. The battery capacity estimation apparatus of claim 3, wherein the statistical analyzing unit is configured to extract a plurality of differential data as one principal component data by performing principal component analysis (PCA) on the plurality of differential data.

5. The battery capacity estimation apparatus of claim 4, wherein the statistical analyzing unit is configured to calculate a plurality of clusters through k-means clustering on the principal component data and determines the differential data as the second data when the differential data is included in a preset cluster.

6. The battery capacity estimation apparatus of claim 5, wherein the statistical analyzing unit is configured to determine differential data not included in the cluster as the first data.

7. The battery capacity estimation apparatus of claim 1, wherein the capacity estimation model is a long short-term memory networks (LSTM) model.

8. The battery capacity estimation apparatus of claim 1, wherein the voltage measuring unit is configured to measure a voltage for a rest period after charging or discharging of the battery cell.

9. The battery capacity estimation apparatus of claim 1, wherein when at least one of a logging time and a number of voltage data of the battery cell deviates from the reference range, the filtering unit determines the voltage data as the first data.

10. The battery capacity estimation apparatus of claim 1, wherein the first data is data in which the voltage data of the battery cell is in a discontinuous form, and the second data is data in which the voltage data of the battery cell is in a continuous form.

11. A battery capacity estimation method comprising:
measuring (S810) a voltage of a battery cell;
determining (S820) voltage data as first data when a logging pattern of the voltage data of the battery cell deviates from a preset reference range;
determining (S830) second data through statistical analysis on the voltage data of the battery cell; and
estimating (S840) a capacity of the battery cell by applying the first data and the second data to capacity estimation models, respectively.

12. The battery capacity estimation method of claim 11, further comprising calculating differential data of a voltage with respect to a time for the battery cell.

13. The battery capacity estimation method of claim 12, further comprising extracting a plurality of differential data as one principal component data by performing principal component analysis (PCA) on the plurality of differential data.

14. The battery capacity estimation method of claim 13, wherein the determining of the second data comprises calculating a plurality of clusters through k-means clustering on the principal component data and determining the differential data as the second data when the differential data is included in a preset cluster.

15. The battery capacity estimation method of claim 14, further comprising determining differential data not included in the cluster as the first data.

## Patentansprüche

1. Batteriekapazität-Schätzvorrichtung, umfassend:
eine Spannung-Messeinheit (210), welche dazu eingerichtet ist, eine Spannung einer Batteriezelle zu messen;
eine Filtereinheit (220), welche dazu eingerichtet ist, Spannungsdaten als erste Daten zu bestimmen, wenn ein Erfassungsmuster der Spannungsdaten der Batteriezelle von einem vorbestimmten Referenzbereich abweicht;
eine statistische Analyseeinheit (230), welche dazu eingerichtet ist, zweite Daten durch statistische Analyse auf die Spannungsdaten der Batteriezelle zu bestimmen; und
eine Kapazität-Schätzeinheit (240), welche dazu eingerichtet ist, eine Kapazität durch Anwenden von Daten, welche durch die Filtereinheit oder die statistische Analyseeinheit für eine Batteriezelle klassifiziert werden, welche ein Messungsziel ist, auf Kapazität-Schätzmodelle zu schätzen, welche separat für die ersten Daten und die zweiten Daten erzeugt werden.

2. Batteriekapazität-Schätzvorrichtung nach Anspruch 1, wobei die statistische Analyseeinheit dazu eingerichtet ist, eine statistische Analyse auf andere Daten als Daten anzuwenden, welche als die ersten Daten von der Filtereinheit bestimmt werden.

3. Batteriekapazität-Schätzvorrichtung nach Anspruch 1, wobei die statistische Analyseeinheit dazu eingerichtet ist, differentielle Daten einer Spannung der Batteriezelle bezüglich einer Zeit zu berechnen.

4. Batteriekapazität-Schätzvorrichtung nach Anspruch 3, wobei die statistische Analyseeinheit dazu eingerichtet ist, eine Mehrzahl von differentiellen Daten als prinzipielle Komponentendaten durch Durchführen einer prinzipiellen Komponenten-Analyse (PCA) auf die Mehrzahl von differentiellen Daten zu extrahieren.

5. Batteriekapazität-Schätzvorrichtung nach Anspruch 4, wobei die statistische Analyseeinheit dazu eingerichtet ist, eine Mehrzahl von Clustern durch k-Means-Clustern auf die prinzipiellen Komponentendaten zu berechnen, und die differentiellen Daten als die zweiten Daten bestimmt, wenn die differentiellen Daten in einem vorbestimmten Cluster umfasst sind.

6. Batteriekapazität-Schätzvorrichtung nach Anspruch 5, wobei die statistische Analyseeinheit dazu eingerichtet ist, differentielle Daten, welche nicht in dem Cluster umfasst sind, als die ersten Daten zu bestimmen.

7. Batteriekapazität-Schätzvorrichtung nach Anspruch 1, wobei das Kapazität-Schätzmodell ein langes Kurzzeitgedächtnis-Netzwerke (LSTM)- Modell ist.

8. Batteriekapazität-Schätzvorrichtung nach Anspruch 1, wobei die Spannung-Messeinheit dazu eingerichtet ist, eine Spannung für eine Ruheperiode nach einem Laden oder Entladen der Batteriezelle zu messen.

9. Batteriekapazität-Schätzvorrichtung nach Anspruch 1, wobei wenn wenigstens eines aus einer Erfassungszeit und einer Anzahl von Spannungsdaten der Batteriezelle von dem Referenzbereich abweicht, die Filtereinheit die Spannungsdaten als die ersten Daten bestimmt.

10. Batteriekapazität-Schätzvorrichtung nach Anspruch 1, wobei die ersten Daten Daten sind, in welchen die Spannungsdaten der Batteriezelle in einer diskontinuierlichen Form vorliegen, und die zweiten Daten Daten sind, in welchen die Spannungsdaten der Batteriezelle in einer kontinuierlichen Form vorliegen.

11. Batteriekapazität-Schätzverfahren, umfassend:
Messen (S810) einer Spannung einer Batteriezelle;
Bestimmen (S820) von Spannungsdaten als erste Daten, wenn ein Erfassungsmuster der Spannungsdaten der Batteriezelle von einem vorbestimmten Referenzbereich abweicht;
Bestimmen (S830) von zweiten Daten durch statistische Analyse auf die Spannungsdaten der Batteriezelle; und
Schätzen (S840) einer Kapazität der Batteriezelle durch jeweiliges Anwenden der ersten Daten und der zweiten Daten auf Kapazität-Schätzmodelle.

12. Batteriekapazität-Schätzverfahren nach Anspruch 11, ferner umfassend ein Berechnen von differentiellen Daten einer Spannung bezüglich einer Zeit für die Batteriezelle.

13. Batteriekapazität-Schätzverfahren nach Anspruch 12, ferner umfassend ein Extrahieren einer Mehrzahl von differentiellen Daten als prinzipielle Komponentendaten durch Durchführen einer prinzipiellen Komponentenanalyse (PCA) auf die Mehrzahl von differentiellen Daten.

14. Batteriekapazität-Schätzverfahren nach Anspruch 13, wobei das Bestimmen der zweiten Daten ein Berechnen einer Mehrzahl von Clustern durch k-Means-Clustern auf die prinzipiellen Komponentendaten und Bestimmen der differentiellen Daten als die zweiten Daten umfasst, wenn die differentiellen Daten in einem vorbestimmten Cluster umfasst sind.

15. Batteriekapazität-Schätzverfahren nach Anspruch 14, ferner umfassend ein Bestimmen von differentiellen Daten, welche nicht in dem Cluster umfasst sind, als die ersten Daten.

## Revendications

1. Appareil d'estimation de capacité de batterie comprenant :
une unité de mesure de tension (210) configurée pour mesurer une tension d'une cellule de batterie ;
une unité de filtrage (220) configurée pour déterminer des données de tension comme étant des premières données lorsqu'un schéma
d'enregistrement des données de tension de la cellule de batterie s'écarte d'une plage de référence prédéfinie ;
une unité d'analyse statistique (230) configurée pour déterminer des secondes données par analyse statistique sur les données de tension de la cellule de batterie ; et
une unité d'estimation de capacité (240) configurée pour estimer une capacité en appliquant des données,
classées par l'unité de filtrage ou l'unité d'analyse statistique pour une cellule de batterie qui est une cible de mesure, à des modèles d'estimation de capacité générés séparément pour les premières données et les secondes données.

2. Appareil d'estimation de capacité de batterie selon la revendication 1, dans lequel l'unité d'analyse statistique est configurée pour effectuer une analyse statistique sur des données autres que des données déterminées comme étant les premières données par l'unité de filtrage.

3. Appareil d'estimation de capacité de batterie selon la revendication 1, dans lequel l'unité d'analyse statistique est configurée pour calculer des données différentielles d'une tension de la cellule de batterie par rapport à un temps.

4. Appareil d'estimation de capacité de batterie selon la revendication 3, dans lequel l'unité d'analyse statistique est configurée pour extraire une pluralité de données différentielles en tant que données d'une composante principale en effectuant une analyse en composantes principales (PCA) sur la pluralité de données différentielles.

5. Appareil d'estimation de capacité de batterie selon la revendication 4, dans lequel l'unité d'analyse statistique est configurée pour calculer une pluralité de groupes par regroupement de k-moyennes sur les données de composante principale et détermine les données différentielles comme étant les secondes données lorsque les données différentielles sont comprises dans un groupe prédéfini.

6. Appareil d'estimation de capacité de batterie selon la revendication 5, dans lequel l'unité d'analyse statistique est configurée pour déterminer des données différentielles non comprises dans le groupe comme étant les premières données.

7. Appareil d'estimation de capacité de batterie selon la revendication 1, dans lequel le modèle d'estimation de capacité est un modèle de réseaux de longue mémoire à court terme (LSTM).

8. Appareil d'estimation de capacité de batterie selon la revendication 1, dans lequel l'unité de mesure de tension est configurée pour mesurer une tension pendant une période de repos après la charge ou la décharge de la cellule de batterie.

9. Appareil d'estimation de capacité de batterie selon la revendication 1, dans lequel, lorsqu'au moins un parmi un temps d'enregistrement et un nombre de données de tension de la cellule de batterie s'écarte de la plage de référence, l'unité de filtrage détermine les données de tension comme étant les premières données.

10. Appareil d'estimation de capacité de batterie selon la revendication 1, dans lequel les premières données sont des données dans lesquelles les données de tension de la cellule de batterie sont sous une forme discontinue, et les secondes données sont des données dans lesquelles les données de tension de la cellule de batterie sont sous une forme continue.

11. Procédé d'estimation de capacité de batterie comprenant :
la mesure (S810) d'une tension d'une cellule de batterie ;
la détermination (S820) de données de tension comme étant des premières données lorsqu'un schéma d'enregistrement des données de tension de la cellule de batterie s'écarte d'une plage de référence prédéfinie ;
la détermination (S830) de secondes données par analyse statistique sur les données de tension de la cellule de batterie ; et
l'estimation (S840) d'une capacité de la cellule de batterie en appliquant les premières données et les secondes données à des modèles d'estimation de capacité, respectivement.

12. Procédé d'estimation de capacité de batterie selon la revendication 11, comprenant en outre le calcul de données différentielles d'une tension par rapport à un temps pour la cellule de batterie.

13. Procédé d'estimation de capacité de batterie selon la revendication 12, comprenant en outre l'extraction d'une pluralité de données différentielles en tant que données d'une composante principale en effectuant une analyse en composantes principales (PCA) sur la pluralité de données différentielles.

14. Procédé d'estimation de capacité de batterie selon la revendication 13, dans lequel la détermination des secondes données comprend le calcul d'une pluralité de groupes par regroupement de k-moyennes sur les données de composante principale et la détermination des données différentielles comme étant les secondes données lorsque les données différentielles sont comprises dans un groupe prédéfini.

15. Procédé d'estimation de capacité de batterie selon la revendication 14, comprenant en outre la détermination de données différentielles non comprises dans le groupe comme étant les premières données.
